# EUROPÄISCHE PATENTSCHRIFT

(11) **EP 1 238 444 B1**
(45) Veröffentlichungstag und Bekanntmachung des Hinweises auf die Patenterteilung: **13.08.2003**
(21) Anmeldenummer: 00988675.5
(22) Anmeldetag: 01.12.2000
(51) Int. Cl.: H01R 12/12

(54) **UNLÖSBARE ELEKTRISCHE UND MECHANISCHE VERBINDUNG, KONTAKTTEIL FÜR EINE UNLÖSBARE ELEKTRISCHE UND MECHANISCHE VERBINDUNG UND VERFAHREN ZUR HERSTELLUNG EINER UNLÖSBAREN ELEKTRISCHEN UND MECHANISCHEN VERBINDUNG**
UNDETACHABLE ELECTRICAL AND MECHANICAL CONNECTION, CONTACT ELEMENT FOR AN UNDETACHABLE ELECTRICAL AND MECHANICAL CONNECTION AND METHOD FOR PRODUCING SUCH AN ELECTRICAL AND MECHANICAL CONNECTION
CONNEXION ELECTRIQUE ET MECANIQUE NON DETACHABLE, ELEMENT DE CONTACT POUR UNE CONNEXION ELECTRIQUE ET MECANIQUE NON DETACHABLE ET PROCEDE DE FABRICATION DE LADITE CONNEXION

(30) Priorität: 07.12.1999 DE 19958776
(43) Veröffentlichungstag der Anmeldung: 11.09.2002
(73) Patentinhaber: ROBERT BOSCH GMBH, 70442 Stuttgart (DE)
(72) Erfinder: JAKOB, Gert, 70378 Stuttgart (DE); GENTNER, Herbert, 71701 Schwieberdingen (DE); SELIG, Rainer, 71229 Leonberg (DE); LIEGL, Erwin, 71735 Eberdingen (DE); RYSY, Stefan, 71634 Ludwigsburg (DE); ENZNER, Juergen, 91622 Ruegland (DE); LUNZ, Udo, 91344 Waischenfeld (DE); MAIER, Hermann, 71706 Markgroeningen (DE); HAUG, Ralf, 71229 Leonberg (DE)
(86) Internationale Anmeldenummer: DE0004277
(87) Internationale Veröffentlichungsnummer: WO01043234

(56) Entgegenhaltungen:
- DE-A- 19 719 455
- GB-A- 1 255 246
- GB-A- 2 217 527
- US-A- 5 387 113
- US-A- 5 779 498

## Beschreibung

Die Erfindung betrifft eine unlösbare elektrische und mechanische Verbindung gemäß Oberbegriff des Anspruchs 1, ein Kontaktteil für eine unlösbare elektrische und mechanische Verbindung gemäß Oberbegriff des Anspruchs 18 sowie ein Verfahren zur Herstellung einer unlösbaren elektrischen und mechanischen Verbindung gemäß Oberbegriff des Anspruchs 19.

### Stand der Technik

Im Zuge dieser Anmeldung wird unter einer unlösbaren elektrischen und mechanischen Verbindung eine Verbindung verstanden, bei der das Kontaktteil und das Gegenkontaktteil fest, beispielsweise durch Kleben, miteinander verbunden sind, wobei also deren Trennung nicht ohne weiteres durchgeführt werden kann.

Eine unlösbare elektrische und mechanische Verbindung ist beispielsweise aus der DE 197 19 455 C2 bekannt. Die elektrische und mechanische Verbindung weist ein Kontakte umfassendes Kontaktteil und ein Gegenkontakte besitzendes Gegenkontaktteil auf. Die Kontakte und Gegenkontakte sind in zwei Reihen hintereinander angeordnet. Um eine Verbindung mit dem Kontaktteil herzustellen, ist dieses mit seiner einen Kontaktreihe auf einer der Reihen der Gegenkontakte befestigt. Um die andere Gegenkontaktreihe kontaktieren zu können, ist von der anderen Kontaktreihe eine Art Schleife auf das Gegenkontaktteil geführt. Diese Schleife überspannt also die erste Kontaktreihe und ist auf der zweiten Gegenkontaktreihe befestigt. Nachteilig hierbei ist, dass die beiden Kontaktreihenpaare (Kontaktreihe und Gegenkontaktreihe) nacheinander hergestellt werden müssen. Außerdem ist nachteilig, dass die Kontaktierungsdichte relativ gering ist.

### Vorteile der Erfindung

Die unlösbare elektrische und mechanische Verbindung mit den im Anspruch 1 genannten Merkmalen sowie das Verfahren zur Herstellung einer derartigen Verbindung nach Anspruch 19 bieten demgegenüber den Vorteil, dass eine Kostenreduzierung und Zeitersparnis bei der Herstellung der Verbindung möglich ist, da sämtliche Kontakte gleichzeitig mit den Gegenkontakten am Gegenkontaktteil verbunden werden können. Außerdem zeichnet sich die unlösbare Verbindung durch eine sehr flache Bauweise aus, da eine im Stand der Technik bekannte Schleife beziehungsweise Überspannung nicht verwendet werden muss. Dennoch bietet die erfindungsgemäße unlösbare elektrische und mechanische Verbindung eine hohe Zuverlässigkeit hinsichtlich mechanischer Festigkeit und elektrischer Verbindung, also Leitfähigkeit zwischen den Kontakten und Gegenkontakten. Außerdem ergibt sich eine Platzeinsparung, insbesondere dann, wenn die Gegenkontakte auf einem Schaltungsträger vorgesehen sind, da diese dann an der Ober- und Unterseite des Schaltungsträgers mit den entsprechenden Gegenkontakten befestigt werden können. Mit dem erfindungsgemäßen Kontaktteil mit den Merkmalen des Anspruchs 18 lassen sich mit einem geeigneten Gegenkontaktteil dieselben Vorteile erzielen.

Um die mechanische Verbindung zwischen dem Kontaktteil und Gegenkontaktteil einfach und schnell herstellen zu können, ist zumindest eine Klebestelle vorgesehen. Für die elektrische Verbindung ist zwischen den Kontakten und den Gegenkontakten ein elektrisch leitendes Kontaktmittel angeordnet.

Bei einem bevorzugten Ausführungsbeispiel wird für die elektrische und mechanische Verbindung zumindest eine anisotrop elektrisch leitende Klebestelle hergestellt. Die Klebestelle kann also den gesamten Kontaktierungs- beziehungsweise Gegenkontaktierungsbereich benetzen, ohne dass darauf geachtet werden muss, die Kontakte und/oder die Gegenkontakte auszusparen. Derartige anisotrop elektrisch leitende Klebstoffe weisen beispielsweise elektrisch leitende Partikel auf, die sich beim Herstellen der Verbindung zwischen jedem Kontakt und dem zugeordneten Gegenkontakt verteilen und so die elektrische Verbindung zwischen einem Kontakt- und Gegenkontaktpaar herstellen. Die mechanische Verbindung erfolgt dabei auf bekannte Art und Weise durch Adhäsion des Klebstoffes an den zu verbindenden Materialien. Derartige anisotrop leitende Klebstoffe werden auch als gefüllte Klebstoffe bezeichnet.

Nach einem anderen Ausführungsbeispiel ist vorgesehen, dass die mechanische Verbindung mit einem ungefüllten Klebstoff hergestellt wird und die elektrische Verbindung, also das Kontaktmittel durch einen elektrisch leitenden Film gebildet ist. Es kann jedoch auch vorgesehen sein, dass die elektrische Verbindung durch direkten Kontakt zwischen Kontakt und Gegenkontakt hergestellt wird. Auf ein Kontaktmittel kann also auch verzichtet werden. Alternativ kann vorgesehen sein, dass die elektrische Kontaktierung mittels Löten erfolgt, also das Kontaktmittel eine lötbare metallische Legierung aufweist. Das Kontaktmittel kann durch eine zwischen jedem Kontakt und dem zugeordneten Gegenkontakt hergestellte an sich bekannte Bügellötstelle oder Laserlötstelle gebildet sein.

Es zeigt sich also, dass es entweder möglich ist, für die elektrische und mechanische Verbindung ein gemeinsames Verbindungsmittel zu verwenden oder aber für die mechanische und die elektrische Verbindung jeweils ein separates Verbindungsmittel vorzusehen. Insbesondere ist vorgesehen, dass das beziehungsweise die Verbindungsmittel mittels Laminieren, Schablonendruck, Dispensen oder Siebdruck aufgetragen werden. Damit kann/können das/die Verbindungsmittel einfach an den dafür vorgesehen Stellen aufgetragen werden.

Besonders bevorzugt wird ein Ausführungsbeispiel, bei dem ein Schaltungsträger, der elektrische Bauteile umfasst, das Gegenkontaktteil aufweist. Mit der erfindungsgemäßen Verbindung kann also leicht eine elektrische und mechanische Verbindung von dem Kontaktteil zu dem Schaltungsträger hergestellt werden.

Bei einer Ausführungsvariante ist vorgesehen, dass das Kontaktteil mit einem Sensorelement verbunden ist, so dass dieses leicht an den vorstehend erwähnten Schaltungsträger angebunden werden kann. Somit lässt sich eine kompakte Einheit aus Schaltungsträger und Sensorelement herstellen, die insbesondere eine geringe Bauhöhe aufweist.

Bevorzugt wird eine Ausführungsform, bei der das Kontaktteil und das Sensorelement einstückig ausgebildet sind, wobei das Sensorelement insbesondere als eine zumindest einen Sensor aufweisende flexible Sensormatte realisiert ist. Derartige Sensormatten werden insbesondere in der Kraftfahrzeugtechnik zur Insassenklassifizierung und/oder für automatische Kindersitzerkennung verwendet. Derartige Sensormatten sind vorzugsweise drucksensitiv ausgebildet. Selbstverständlich kann jedoch auch jedes andere Sensorelement mit dem erfindungsgemäßen Kontaktteil ausgestattet sein oder dieses aufweisen. Es sind also auch andere physikalische Größen erfassende Sensorelemente mit dem erfindungsgemäßen Kontaktteil an einem Schaltungsträger anschließbar.

Dadurch, dass zwischen den Lagen des Kontaktteils das Gegenkontaktteil aufgenommen wird, können insbesondere die Kontakte als Kontaktreihe oder -matrix angeordnet werden. Die Gegenkontakte sind entsprechend als Gegenkontaktreihe oder -matrix an dem Gegenkontaktteil, insbesondere Schaltungsträger, angeordnet.

Bevorzugt sind die Kontakte und Gegenkontakte Leiterbahnenden. Bevorzugt wird hierbei, dass das Leiterbahnende verbreitert gegenüber der übrigen Leiterbahn ausgebildet ist, so dass an sich bekannte Kontakt-Pads gebildet sind.

Die Leiterbahnen am Kontaktteil können beispielsweise als Silberleiterbahnen ausgebildet sind, die vorzugsweise mit Graphit abgedeckt sind. Derartige Silberleitbahnen sind kostengünstig herstellbar.

Für ein bevorzugtes Ausführungsbeispiel ist der Schaltungsträger als flexibles oder starres Substrat realisiert. Selbstverständlich kann der Schaltungsträger auch mehrlagig sein. Insbesondere werden hierfür als Leiterplattenwerkstoffe FR4 und LTCC vorgesehen. Selbstverständlich sind andere beliebige Leiterplattenmaterialien verwendbar, insbesondere Keramiksubstrate. Die Oberfläche des Schaltungsträgers kann beispielsweise Kupfer/ Nickel/Gold und/oder Kupfer umfassen.

Weitere Ausführungsbeispiele ergeben sich aus den Unteransprüchen.

### Zeichnung

Die Erfindung wird nachfolgend anhand von Ausführungsbeispielen mit Bezug auf die Zeichnungen näher erläutert. Es zeigen:
- Figur 1: ein Sensorelement mit zugehörigem Schaltungsträger, wobei Sensorelement und Schaltungsträger über eine unlösbare elektrische und mechanische Verbindung miteinander verbunden sind,
- Figur 2: eine Schnittdarstellung eines den Schaltungsträger und die Verbindung aufnehmenden Gehäuses,
- Figur 3: eine weitere Schnittdarstellung des Gehäuses,
- Figur 4: eine Draufsicht auf den Schaltungsträger,
- Figur 5: eine Draufsicht auf eine Lage des Kontaktteils der Verbindung, und
- Figuren 6A und 6B: jeweils ein Ausführungsbeispiel einer elektrischen und mechanischen Verbindung in Schnittansicht.

### Beschreibung der Ausführungsbeispiele

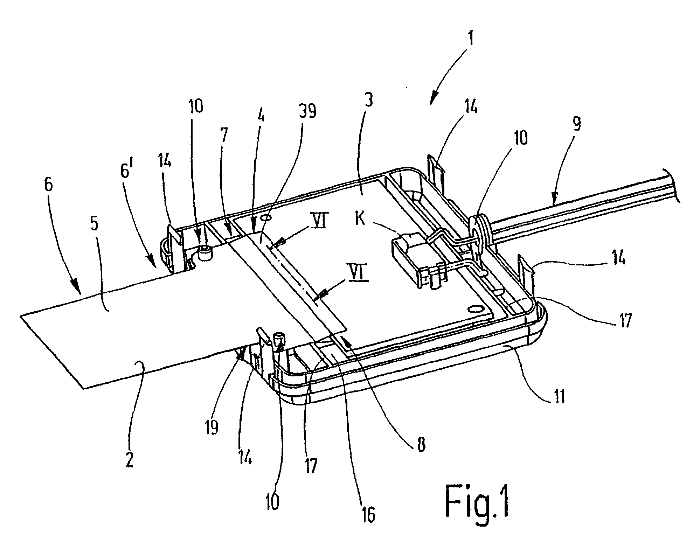

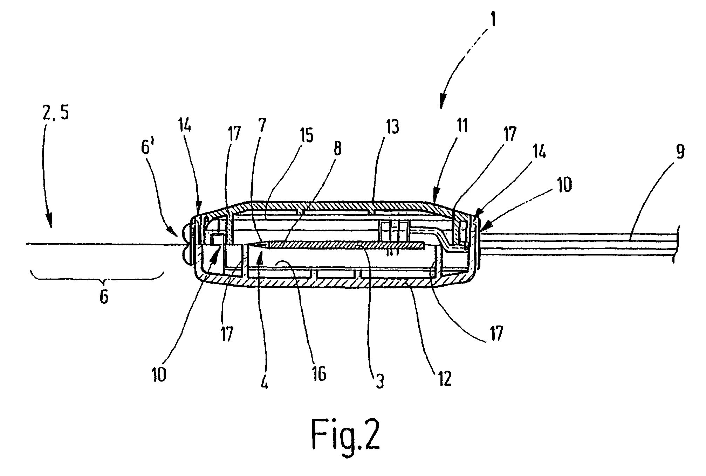

Anhand der Figuren 1 bis 3 wird nachfolgend der Aufbau einer Sensorvorrichtung 1 näher beschrieben, die ein Sensorelement 2 und einen Schaltungsträger 3, vorzugsweise mit zum Sensorelement 2 zugehöriger Signal-Erfassungsschaltung, umfasst. Sensorelement 2 und Schaltungsträger 3 sind mit einer elektrischen und mechanischen Verbindung 4 miteinander verbunden.

Das Sensorelement 2 ist im Ausführungsbeispiel als sogenannte Sensormatte 5 ausgebildet, die einen Sensorbereich 6 mit zumindest einem Sensor, ein Leiterbahnen tragendes Mittelteil 6' und ein Kontaktteil 7 der Verbindung 4 umfasst. Der Schaltungsträger 3 weist somit ein Gegenkontaktteil 8 der Verbindung 4 auf. Der Schaltungsträger 3 ist mit einer hier nicht dargestellten Sensor-Auswerteeinrichtung über einen elektrischen Anschluss 9 verbunden, der als Kabelanschluss ausgebildet sein kann. Das Kabel ist mit einer Zugentlastung 10 in ein Gehäuse 11 geführt. Die einzelnen Kabel des elektrischen Anschlusses 9 sind auf dem Schaltungsträger 3 kontaktiert (Bezugszeichen K).

Das Gehäuse 11 besitzt ein Gehäuseunterteil 12 und ein Gehäuseoberteil 13, die halbschalenartig ausgebildet sein können. Vorzugsweise ist vorgesehen, das Gehäuseunter- und -oberteil 12 und 13 mit einer in Figur 1 dargestellten Rastverbindung 14 aneinander befestigt werden. Das Gehäuse 11 nimmt somit der. Schaltungsträger 3 und die Verbindung 4 auf. Die Sensormatte 5 ragt also aus dem Gehäuse 11 heraus, so dass der Sensorbereich 6 außerhalb des Gehäuses 11 liegt. Auch das Sensorelement 2 ist mit einer Zugentlastung 10 am Gehäuse 11 befestigt.

Gehäuseunter- und -oberteil 12 und 13 weisen jeweils eine Wanne 15 und 16 auf, die durch Trennwände 17 und Gehäuseseitenwände gebildet sind, wobei die Trennwände 17 parallel zueinander am Gehäuseboden jedes Gehäuseteils 12 und 13 verlaufen. Der Abstand der Trennwände 17 jeder Wanne 15 beziehungsweise 16 ist so bemessen, dass der Schaltungsträger und die Verbindung 4 innerhalb der Trennwände 17 liegen. Vor oder nach dem Verschließen des Gehäuses 11 wird in die beiden Wannen 15 und 16 eine Vergussmasse 18 eingebracht, die die Wannen 15 und 16 ausfüllt und somit den Schaltungsträger 3 und die Verbindung 4 fixiert und schützt.

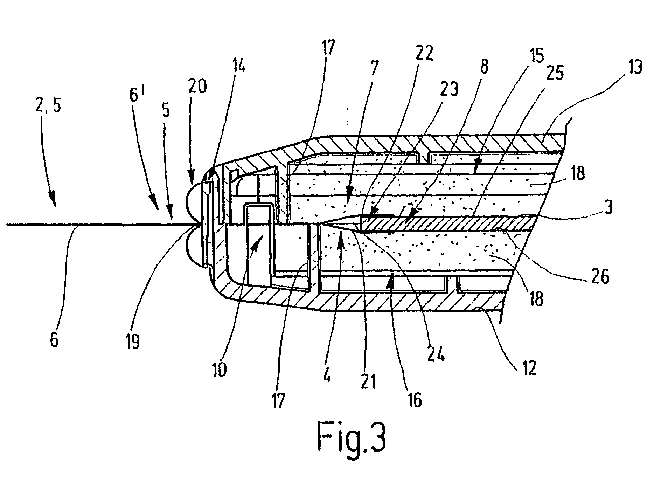

Aus Figur 3 geht noch hervor, dass die benachbart zu einer Gehäuseöffnung 19 liegenden Trennwände 17 der oberen und unteren Wanne 15 und 16 einen Versatz zueinander aufweisen, so dass die Sensormatte 5 mit ihrem Mittelteil 6' zwischen diesen beiden Trennwänden 17 hindurchgeführt werden kann, um durch die Gehäuseöffnung 19 hindurchzutreten. An der Außenseite des Gehäuses 19 ist die Gehäuseöffnung 19 noch von einem Knickschutz 20 zumindest bereichsweise umgeben, der die Sensormatte 5 im Bereich der Gehäuseöffnung 19 schützt.

Gemäß Figur 3 umfasst das Kontaktteil 7 zumindest zwei Lagen 21 und 22, die zwischen sich einen Zwischenraum 23 einschließen. Sind das Kontaktteil 7 und die Sensormatte 5 einstückig ausgebildet, so sind diese Lagen 21 und 22 Bestandteil des Sensorelements 2 und können zwischen sich den zumindest einen Sensor aufnehmen. Zwischen diesen beiden Lagen 21 und 22 kann eine Zwischenlage 24 angeordnet sein, die die auf den Lageninnenseiten liegenden Leiterbahnen elektrisch voneinander isoliert. Die Zwischenlage 24 kann sich bis in den Sensorbereich 6 erstrecken und so als Abstandhalter dienen. Die obere Lage 22 ist mit der Oberseite 25 des Schaltungsträgers verbunden. Die untere Lage 21 ist entsprechend mit der Unterseite 26 des Schaltungsträgers 3 verbunden. Somit wird klar, dass der Schaltungsträger 3 mit seinem Gegenkontaktteil 8 in dem Zwischenraum 23 zu liegen kommt.

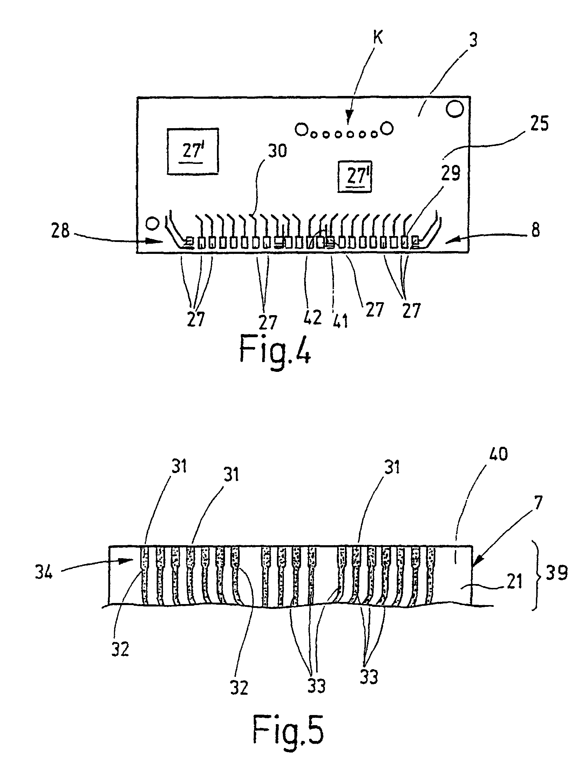

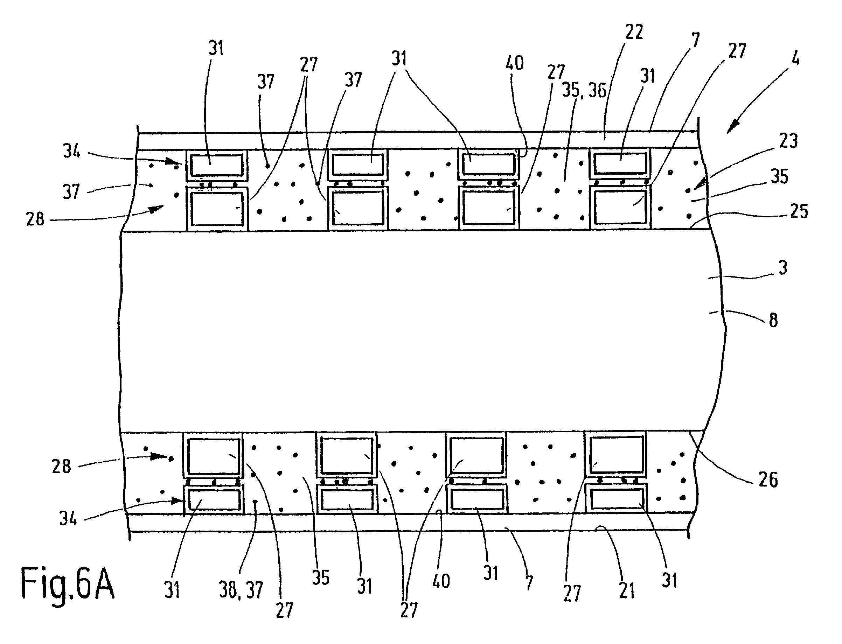

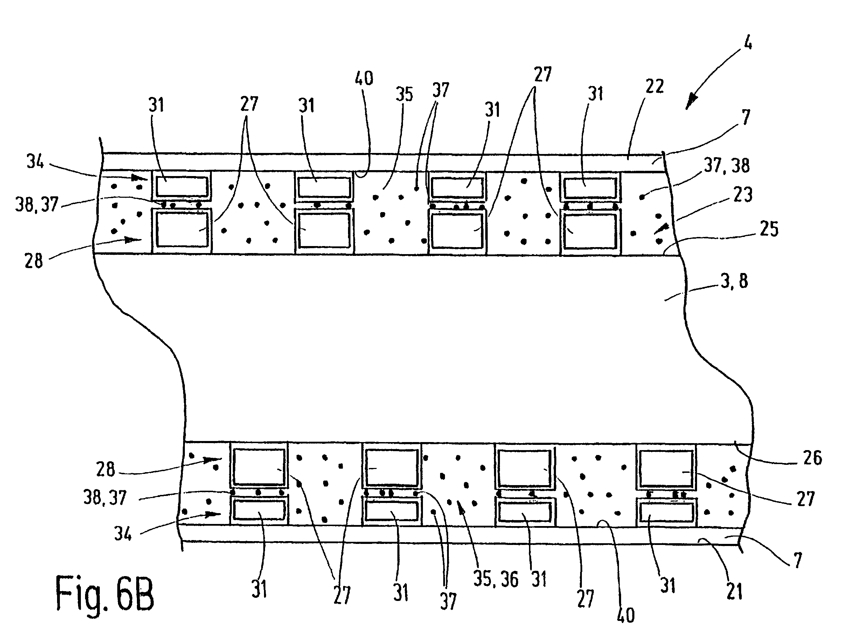

Figur 4 zeigt den Schaltungsträger 3 in Draufsicht. Er weist elektrische beziehungsweise elektronische Bauteile 27' der Signal-Erfassungsschaltung und -wie bereits erwähnt- das Gegenkontaktteil 8 auf, das mehrere Gegenkontakte 27 besitzt, die hier eine Gegenkontaktreihe 28 auf der Oberseite 25 bilden, bei der die einzelnen Gegenkontakte 27 einen Abstand zueinander aufweisen. Die Gegenkontakte 27 befinden sich an Enden 29 von Leiterbahnen 30, die zu den elektrischen beziehungsweise elektronischen Bauelementen 27' führen. Auch die hier nicht dargestellte Unterseite 26 des Schaltungsträgers 3 weist mehrere Gegenkontakte 27 auf, die ebenfalls in bevorzugter Ausführungsform eine Gegenkontaktreihe 28 (Figuren 6A und 6B) bilden.

Figur 5 zeigt ausschnittweise das Kontaktteil 7, wobei hier lediglich eine Lage 21 des Mittelteils 6' der Sensormatte 5 wiedergegeben ist. Das Kontaktteil 7 weist mehrere Kontakte 31 auf, die von Enden 32 von Leiterbahnen 33, die zu dem zumindest einen Sensor führen, gebildet sind. Die Kontakte 31 sind entsprechend der Anordnung der Gegenkontakte 27 in einer Kontaktreihe 34 angeordnet, wobei die Mittenabstände zwischen zwei Kontakten 31 den Mittenabständen zwischen zwei Gegenkontakten 27 entsprechen, so dass diese fluchtend übereinander gebracht werden können.

Figur 6A zeigt in Schnittdarstellung gemäß Linie VI-VI in Figur 1 die Verbindung 4. Gleiche beziehungsweise gleichwirkende Teile wie in den übrigen Figuren sind mit denselben Bezugszeichen versehen. Für die mechanische Verbindung des Kontaktteils 7 mit dem Gegenkontaktteil 8 ist eine Klebestelle 35 vorgesehen, die im vorliegenden Ausführungsbeispiel auch der elektrischen Verbindung zwischen jedem Kontakt 31 und dem zugehörigen Gegenkontakt 27 dient, da die Klebestelle 35 hier mittels eines anisotrop elektrisch leitenden Klebstoffs 36 realisiert ist. Die anisotrop elektrische Leitfähigkeit der Klebestelle 35 wird im Ausführungsbeispiel durch elektrisch leitende Partikel 37 hergestellt, die zwischen den Kontakten 31 und Gegenkontakten 27 liegen. Mithin bilden diese elektrisch leitenden Partikel 37 ein elektrisch leitendes Kontaktmittel 38 aus, welches der elektrischen Verbindung dient. Anstelle der hier dargestellten Partikel 37 wäre es jedoch auch denkbar, die Klebestelle 35 mit einem nichtleitenden beziehungsweise isolierenden Klebstoff und das Kontaktmittel 38 beispielsweise durch Einbringen einer lötbaren metallischen Legierung herzustellen.

Gemäß Ausführungsbeispiel nach Figur 6B der elektrischen und mechanischen Verbindung 4 sind hier die Kontakte 31 und Gegenkontakte 27 einer Kontaktreihe 34 beziehungsweise Gegenkontaktreihe 28 versetzt zu den anderen Kontakten 31 und Gegenkontakten 27 der anderen Kontaktreihe 34 beziehungsweise Gegenkontaktreihe 28 angeordnet. Diese Ausgestaltung bietet gegenüber dem Ausführungsbeispiel nach Figur 6A den Vorteil, dass auf die Verwendung einer Zwischenlage 24 (Figur 3) im Bereich des Mittelteils 6' verzichtet werden kann. Gleiche Teile wie in den übrigen Figuren sind im übrigen mit denselben Bezugszeichen versehen, so dass insofern auf deren Beschreibung verwiesen werden kann.

Im Folgenden wird noch ein Verfahren zur Herstellung der unlösbaren elektrischen und mechanischen Verbindung 4 zwischen einem mehrere Kontakte 31 aufweisenden Kontaktteil 7 und einem mehrere Gegenkontakte 27 aufweisenden Kontaktteil 8 beschrieben: Zunächst wird die Sensormatte 5 im Bereich des flexiblen Abschnitts 39 (Figur 5) des Mittelteils 6' aufgeweitet, so dass der Zwischenraum 23 für das Gegenkontaktteil 8 gebildet wird. An den Lageninnenseiten 40 (Figur 6A) liegen somit die Kontakte 31 der beiden Lagen 21 und 22 mit Abstand zueinander. Nachfolgend wird der Schaltungsträger 3 mit seinem Gegenkontaktteil 8 in den Zwischenraum 23 eingebracht. Selbstverständlich kann auch die Sensormatte 5 mit ihrem Kontaktteil 7 auf den Schaltungsträger 3 aufgesteckt werden. Anschließend werden Kontaktteil 7 und Gegenkontaktteil 8 so zueinander ausgerichtet, dass die Kontakte 31 über den entsprechenden Gegenkontakten 27 zu liegen kommen. Danach erfolgt die Herstellung der Klebestelle 35, also das Einbringen des Klebstoffs 36, und die elektrische Kontaktierung zwischen den Kontakten 31 und den Gegenkontakten 27. Hierzu wird vorzugsweise vor dem Ineinanderstecken von Kontaktteil 7 und Gegenkontaktteil 8 Klebstoff 36 im Bereich des Gegenkontaktteils 8 auf die Ober- und Unterseite 25 und 26 und die Gegenkontakte 27 aufgetragen. Alternativ oder zusätzlich kann Klebstoff 36 auch auf die Lageninnenseiten 40 und/oder die Kontakte 31 aufgetragen werden. Da vorzugsweise unter Wärme aushärtender Klebstoff 36 verwendet wird, wird anschließend die ausgerichtete Verbindung 4 erwärmt und, vorzugsweise unter Druck, die Kontakte 31 und die Gegenkontakte 27 zusammengebracht, so dass die elektrische und mechanische Verbindung 4 hergestellt ist. Dieser Verfahrensschritt wird auch als Heatsealen bezeichnet.

Wird anstelle des anisotrop elektrisch leitenden Klebstoffs 36 ein elektrisch isolierender Klebstoff verwendet, können die Kontakte 31 und/oder Gegenkontakte 37 mit dem Kontaktmittel 38 versehen werden, das dann insbesondere eine lötbare Metalllegierung umfasst. Zur Aushärtung des Klebstoffs und für die Verflüssigung der lötbaren Metalllegierung wird anschließend Wärme an der Verbindung 4 aufgebracht. Für Kontaktteil 7 und Gegenkontaktteil 8 sind dann wärmebeständige Materialien vorgesehen.

Es kann jedoch auch vorgesehen sein, dass zuerst die Kontakte 31 und Gegenkontakte 27 durch Löten miteinander verbunden werden und dass anschließend ein Klebstoff zwischen den Schaltungsträger 3 und die Lagen 21 und 22 eingebracht wird. Es zeigt sich also, dass eine Vielzahl von Variationsmöglichkeiten hinsichtlich der Ausbildung der elektrischen und der mechanischen Verbindung 4 bestehen.

Um die Qualität insbesondere der elektrischen Kontaktierung zwischen den Gegenkontakten 27 und den Kontakten 31 sicherstellen zu können, werden vorzugsweise während und/oder nach Herstellen der Verbindung 4 Leitfähigkeitsprüfungen vorgenommen. Hierzu ist vorgesehen, dass zumindest einem Gegenkontakt 27 ein Prüfkontakt 41 (Figur 4) zugeordnet ist, der über eine Prüfleiterbahn 42 aus dem Kontaktierungsbereich herausgeführt wird. Die elektrische Verbindung zwischen den Gegenkontakten 27 und den Kontakten 31 kann dadurch messtechnisch erfasst werden. Selbstverständlich kann vorgesehen sein, dass jedem Kontakt 27 ein Prüfkontakt 41 zugeordnet ist.

Bei der erfindungsgemäßen elektrischen und mechanischen Verbindung 4 ist also entscheidend, dass die Kontakte 31 und die Gegenkontakte 27 in zwei unterschiedlichen Ebenen (Oberseite 25 und Unterseite 26) angeordnet sind, die mit Abstand zueinander liegen. Somit kann die Kontaktierungsdichte durch die beidseitige, also übereinanderstehende Kontaktierung zwischen den einzelnen Kontakten 31 und den zugeordneten Gegenkontakten 27 erhöht werden. Die erfindungsgemäße Verbindung 4 zeichnet sich außerdem durch hohe mechanische und elektrische Zuverlässigkeit aus. Bei der Herstellung der elektrischen und mechanischen Verbindung 4 ist außerdem die Prozesszeit durch die gleichzeitige Herstellung der Kontaktierung in beiden Ebenen gewährleistet. Außerdem zeichnet sich die Verbindung 4 durch eine flache Bauweise aus. Überdies sind die Kosten für die Herstellung der Verbindung 4 gering.

Anstelle der Sensormatte 5 kann sich an das Mittelteil 6', das die Leiterbahnen 33 trägt, ein weiteres Kontaktteil 7 anschließen. Damit kann der Schaltungsträger 3 mit einem anderen Schaltungsträger oder einem elektrischen oder elektronischen Bauteil verbunden werden. So ist es möglich, anstatt des Anschlusses 9 mit seinem Kabel einen flexiblen Leiterbahnträger, insbesondere das Mittelteil 6', zu verwenden, der das Kontaktteil 7 besitzt. Mithin weist dann der Schaltungsträger 3 nicht die Kontaktierungen K, sondern ein Gegenkontaktteil 8 auf.

## Patentansprüche

1. Unlösbare elektrische und mechanische Verbindung (4) zwischen einem Kontakte (31) aufweisenden Kontaktteil (7) und einem Gegenkontakte (27) aufweisenden Gegenkontaktteil (8), mit einem zumindest im Bereich der Kontakte (31) vorliegenden flexiblen Abschnitt (39) des Kontaktteils (7), **dadurch gekennzeichnet, dass** das Kontaktteil (7) zumindest eine erste und zweite Lage (21,22) aufweist, die im Bereich des flexiblen Abschnitts (39) einen Zwischenraum (23) zwischen sich aufweisen, in dem das Gegenkontaktteil (8) liegt, dass die erste und zweite Lage (21,22) jeweils zumindest einen Kontakt (31) an den sich zugewandten Lageninnenseiten (40) besitzen und dass das Gegenkontaktteil (8) jeweils an seiner Ober- und Unterseite (25,26) zumindest einen Gegenkontakt (27) aufweist.

2. Unlösbare elektrische und mechanische Verbindung nach Anspruch 1, **dadurch gekennzeichnet, dass** für die mechanische Verbindung zwischen Kontaktteil (7) und Gegenkontaktteil (8) zumindest eine Klebestelle (35) vorliegt.

3. Unlösbare elektrische und mechanische Verbindung nach einem der vorhergehenden Ansprüche, **dadurch gekennzeichnet, dass** für die elektrische Verbindung zwischen den Kontakten (31) und den Gegenkontakten (27) ein elektrisch leitendes Kontaktmittel (38) angeordnet ist.

4. Unlösbare elektrische und mechanische Verbindung nach Anspruch 1 oder 2, **dadurch gekennzeichnet, dass** die Kontakte (31) direkt auf den Gegenkontakten (27) liegen.

5. Unlösbare elektrische und mechanische Verbindung nach einem der vorhergehenden Ansprüche, **dadurch gekennzeichnet, dass** für die elektrische und mechanische Verbindung (4) zumindest eine anisotrop elektrisch leitende Klebestelle (35) gebildet ist.

6. Unlösbare elektrische und mechanische Verbindung nach Anspruch 3, **dadurch gekennzeichnet, dass** das Kontaktmittel (38) ein anisotrop elektrisch leitender Film oder eine Paste ist.

7. Unlösbare elektrische und mechanische Verbindung nach Anspruch 1,2 oder 4, **dadurch gekennzeichnet, dass** die mechanische Verbindung als nichtleitende Klebestelle (35) ausgebildet ist.

8. Unlösbare elektrische und mechanische Verbindung nach Anspruch 3, **dadurch gekennzeichnet, dass** das Kontaktmittel (38) eine lötbare metallische Legierung umfasst.

9. Unlösbare elektrische und mechanische Verbindung nach Anspruch 3, **dadurch gekennzeichnet, dass** jeweils zwischen den Kontakten (31) und Gegenkontakten (27) eine Bügellötstelle oder Laserlötstelle gebildet ist.

10. Unlösbare elektrische und mechanische Verbindung nach einem der vorhergehenden Ansprüche, **da** **durch gekennzeichnet,** dass ein Schaltungsträger (3) das Gegenkontaktteil (8) aufweist.

11. Unlösbare elektrische und mechanische Verbindung nach einem der vorhergehenden Ansprüche, **dadurch gekennzeichnet, dass** das Kontaktteil (7) mit einem Sensorelement (2) verbunden ist.

12. Unlösbare elektrische und mechanische Verbindung nach Anspruch 11, **dadurch gekennzeichnet, dass** das Kontaktteil (7) und das Sensorelement (2) einstückig ausgebildet sind.

13. Unlösbare elektrische und mechanische Verbindung nach Anspruch 11 oder 12, **dadurch gekennzeichnet, dass** das Sensorelement (2) eine zumindest einen Sensor aufweisende flexible Sensormatte (5) aufweist.

14. Unlösbare elektrische und mechanische Verbindung nach einem der vorhergehenden Ansprüche, **dadurch gekennzeichnet, dass** das Kontaktteil (7) und das Gegenkontaktteil (8) jeweils mehrere Kontakte beziehungsweise Gegenkontakte (31,27) aufweisen, wobei die Kontakte (31) als Kontaktreihe (34) oder - matrix beziehungsweise als Gegenkontaktreihe (28) oder -matrix vorliegen.

15. Unlösbare elektrische und mechanische Verbindung nach einem der vorhergehenden Ansprüche, **dadurch gekennzeichnet, dadurch gekennzeichnet, dass** die Kontakte (31) und Gegenkontakte (27) Leiterbahnenden (29,32) sind.

16. Unlösbare elektrische und mechanische Verbindung nach Anspruch 15, **dadurch gekennzeichnet, dass** die Leiterbahnen (33) am Kontaktteil (7) als Silberleitbahnen, vorzugsweise mit Graphit abgedeckt, ausgebildet sind.

17. Unlösbare elektrische und mechanische Verbindung nach einem der vorhergehenden Ansprüche 10-16, **dadurch gekennzeichnet, dass** der Schaltungsträger (3) als flexibles oder starres Substrat realisiert ist.

18. Kontaktteil (7) für eine unlösbare elektrische und mechanische Verbindung (4), die ein Gegenkontaktteil (8) aufweist, wobei das Kontaktteil (7) mehrere Kontakte (31) an einem flexiblen Abschnitt (39) aufweist, insbesondere nach einem der Ansprüche 1 bis 17, **dadurch gekennzeichnet, dass** es zumindest zwei Lagen (21,22) besitzt, die in dem Bereich des flexiblen Abschnitts (39) einen Zwischenraum (23) zwischen sich bilden, in dem das Gegenkontaktteil (8) anordenbar ist, dass die erste und zweite Lage (21,22) jeweils zumindest einen Kontakt (31) an den sich zugewandten Lageninnenseiten (40) besitzen, wobei die Kontakte (31) mit an der Oberund Unterseite (25,26) liegenden Gegenkontakten (27) des Gegenkontaktteils (8) verbindbar sind.

19. Verfahren zur Herstellung einer unlösbaren elektrischen und mechanischen Verbindung (4) zwischen einem mehrere Kontakte (31) aufweisenden Kontaktteil (7) und einem mehrere Gegenkontakte (27) aufweisenden Gegenkontaktteil (8), insbesondere nach einem der Ansprüche 1 bis 17, **dadurch gekennzeichnet, dass** das Kontaktteil (7) an seinem für die Verbindung (4) vorgesehenen Ende aufgeweitet wird, wodurch ein Zwischenraum (23) entsteht, wobei an den Lageninnenseiten (40) die Kontakte (31) liegen, dass die Kontakte (31) zu den Gegenkontakten (27) ausgerichtet werden und dass das Kontaktteil (7) anschließend mechanisch und elektrisch mit dem Gegenkontaktteil (8) verbunden wird.

20. Verfahren nach Anspruch 19, **dadurch gekennzeichnet, dass** während und/oder nach der Herstellung der Verbindung (4) eine Überprüfung der elektrischen Verbindung zwischen den Kontakten (31) und Gegenkontakten (27) erfolgt.

## Claims

1. Permanent electrical and mechanical connection (4) between a contact part (7) having contacts (31) and a mating contact part (8) having mating contacts (27), with the contact part (7) having a flexible section (39) at least in the area of the contacts (31), **characterized in that** the contact part (7) has at least a first and a second layer (21, 22) which layers have a space (23) between them in the area of the flexible section (39), in which intermediate space (23) the mating contact part (8) is located, **in that** the first and the second layer (21, 22) each have at least one contact (31) on the mutually facing layer inner faces (40), and **in that** the mating contact part (8) has at least one mating contact (27) in each case on its upper face and lower face (25, 26).

2. Permanent electrical and mechanical connection according to Claim 1, **characterized in that** at least one adhesion point (35) is provided for the mechanical connection between the contact part (7) and the mating contact part (8).

3. Permanent electrical and mechanical connection according to one of the preceding claims, **characterized in that** an electrically conductive contact means (38) is arranged for the electrical connection between the contacts (31) and the mating contacts (27).

4. Permanent electrical and mechanical connection according to Claim 1 or 2, **characterized in that** the contacts (31) lie directly on the mating contacts (27).

5. Permanent electrical and mechanical connection according to one of the preceding claims, **characterized in that** at least one anisotropically electrically conductive adhesion point (35) is formed for the electrical and mechanical connection (4).

6. Permanent electrical and mechanical connection according to Claim 3, **characterized in that** the contact means (38) is an anisotropically electrically conductive film or a paste.

7. Permanent electrical and mechanical connection according to Claim 1, 2 or 4, **characterized in that** the mechanical connection is in the form of a nonconductive adhesion point (35).

8. Permanent electrical and mechanical connection according to Claim 3, **characterized in that** the contact means (38) is formed from a metallic alloy which can be soldered.

9. Permanent electrical and mechanical connection according to Claim 3, **characterized in that** a point for a soldering iron or a point for laser soldering is in each case formed between the contacts (31) and the mating contacts (27).

10. Permanent electrical and mechanical connection according to one of the preceding claims, **characterized in that** a circuit substrate (3) has the mating contact part (8).

11. Permanent electrical and mechanical connection according to one of the preceding claims, **characterized in that** the contact part (7) is connected to a sensor element (2).

12. Permanent electrical and mechanical connection according to Claim 11, **characterized in that** the contact part (7) and the sensor element (2) are formed integrally.

13. Permanent electrical and mechanical connection according to Claim 11 or 12, **characterized in that** the sensor element (2) has a flexible sensor mat (5) which has at least one sensor.

14. Permanent electrical and mechanical connection according to one of the preceding claims, **characterized in that** the contact part (7) and the mating contact part (8) each have a number of contacts and mating contacts (31, 27), respectively, with the contacts (31) being in the form of a contact row (34) or matrix or, respectively, being in the form of a mating contact row (28) or matrix.

15. Permanent electrical and mechanical connection according to one of the preceding claims, **characterized in that** the contacts (31) and mating contacts (27) are conductor track ends (29, 32).

16. Permanent electrical and mechanical connection according to Claim 15, **characterized in that** the conductor tracks (33) on the contact part (7) are in the form of silver conductor tracks, preferably covered with graphite.

17. Permanent electrical and mechanical connection according to one of the preceding Claims 10 - 16, **characterized in that** the circuit substrate (3) is in the form of a flexible or rigid substrate.

18. Contact part (7) for a permanent electrical and mechanical connection (4) which has a mating contact part (8), with the contact part (7) having two or more contacts (31) on a flexible section (39), in particular according to one of Claims 1 to 17, **characterized in that** the contact part (7) has at least two layers (21, 22), which form a space (23) between them in the area of the flexible section (39), in which intermediate space (23) the mating contact part (8) can be arranged, **in that** the first and the second layer (21, 22) each have at least one contact (31) on the mutually facing layer inner faces (40), in which case the contacts (31) can be connected to mating contacts (27), which are located on the upper face and lower face (25, 26), of the mating contact part (8).

19. Method for producing a permanent electrical and mechanical connection (4) between a contact part (7) which has two or more contacts (31) and a mating contact part (8) which has two or more mating contacts (27), in particular according to one of Claims 1 to 17, **characterized in that** the contact part (7) is widened at its end which is provided for the connection (4), thus resulting in an intermediate space (23), with the contacts (31) lying on the layer inner faces (40), **in that** the contacts (31) are aligned with respect to the mating contacts (27), and **in that** the contact part (7) is subsequently mechanically and electrically connected to the mating contact part (8).

20. Method according to Claim 19, **characterized in that** the electrical connection between the contacts (31) and the mating contacts (27) is checked during and/or after the production of the connection (4).

## Revendications

1. Connexion électrique et mécanique (4) solidaire, entre une pièce de contact (7) ayant des contacts (31) et une pièce de contact complémentaire (8) ayant des contacts complémentaires (27), avec un segment souple (39) de la pièce de contact (7), qui se trouve dans la zone des contacts (31),
**caractérisée en ce que**
la pièce de contact (7) comporté au moins une première et une seconde couche (21, 22),
ces couches forment, entre elles au niveau du segment souple (39), un espace intermédiaire (23), dans lequel se place la pièce de contact complémentaire (8),
la premicre et la seconde coudhe (21, 22) ayant chaque fois au moins un contact (31) sur les côtés intérieurs des couches (40) tournés l'un vers l'autre et
la pièce de contact complémentaire (8) comporte chaque fois au moins un contact complémentaire (27) sur sa face supérieure et sa face inférieure (25, 26).

2. Connexion électrique et mécanique solidaire selon la revendication 1,
**caractérisée par**
au moins un point de collage (35) pour réaliser la liaison mécanique entre la pièce de contact (7) et la pièce de contact complémentaire (8).

3. Connexion électrique et mécanique solidaire selon l'une des revendications précédentes,
**caractérisée par**
un moyen de contact (38) conducteur électrique pour réaliser la liaison électrique entre les contacts (31) et les contacts complémentaires (27).

4. Connexion électrique et mécanique solidaire selon les revendications 1 ou 2,
**caractérisée en ce que**
les contacts (31) sont appliqués directement contre les contacts complémentaires (27).

5. Connexion électrique et mécanique solidaire selon l'une des revendications précédentes,
**caractérisée par**
au moins un point de collage (35) à conduction électrique anisotrope pour la liaison électrique et mécanique (4).

6. Connexion électrique et mécanique solidaire selon la revendication 3,
**caractérisée en ce que**
le moyen de contact (38) est un film ou une pâte électroconductrice anisotrope.

7. Connexion électrique et mécanique solidaire selon les revendications 1, 2 ou 4,
**caractérisée en ce que**
la liaison mécanique est réalisée comme point de collage (35) non conducteur.

8. Connexion électrique et mécanique solidaire selon la revendication 3,
**caractérisée en ce que**
le moyen de contact (38) comprend un alliage métallique susceptible d'être soudé.

9. Connexion électrique et mécanique solidaire selon la revendication 3,
**caractérisée par**
un point de brasage au fer ou au laser entre chaque fois les contacts (31) et les contacts complémentaires (27).

10. Connexion électrique et mécanique solidaire selon l'une des revendications précédentes,
**caractérisée par**
un support de circuit (3) muni de la pièce de contact complémentaire (8).

11. Connexion électrique et mécanique solidaire selon l'une des revendications précédentes,
**caractérisée en ce que**
la pièce de contact (7) est reliée à un élément de capteur (2).

12. Connexion électrique et mécanique solidaire selon la revendication 11,
**caractérisée en ce que**
la pièce de contact (7) et l'élément de capteur (2) sont réalisés en une seule pièce.

13. Connexion électrique et mécanique solidaire selon la revendication 11 ou 12,
**caractérisée en ce que**
l'élément de capteur (2) comporte une nappe de capteur (5), souple, ayant au moins un capteur.

14. Connexion électrique et mécanique solidaire selon l'une des revendications précédentes,
**caractérisée en ce que**
la pièce de contact (7) et la pièce de contact complémentaire (8) ont chaque fois plusieurs contacts ou contacts complémentaires (31, 27), les contacts (31) étant sous la forme de rangées de contacts (34) ou de matrices de contacts ou de rangées de contacts complémentaires (28) ou de matrices de contacts complémentaires.

15. Connexion électrique et mécanique solidaire selon l'une des revendications précédentes,
**caractérisée en ce que**
les contacts (31) et les contacts complémentaires (27) sont des chemins conducteurs (29, 32).

16. Connexion électrique et mécanique solidaire selon la revendication 15,
**caractérisée en ce que**
les chemins conducteurs (33) sont réalisés sur la pièce de contact (7) sous la forme de chemins conducteurs en argent couvert de préférence par du graphite.

17. Connexion électrique et mécanique solidaire selon l'une des revendications 10 à 16,
**caractérisée en ce que**
le support de circuit (3) est réalisé sous la forme d'un substrat souple ou rigide.

18. Pièce de contact (7) pour une liaison mécanique et électrique (4), solidaire, ayant une pièce de contact complémentaire (8), la pièce de contact (7) ayant plusieurs contacts (31) sur un segment souple (39), notamment selon l'une des revendications 1 à 17,
**caractérisée en ce que**
cette pièce comporte au moins deux couches (21, 22) qui forment entre elles un espace intermédiaire (23) au niveau du segment souple (39), espace recevant la pièce de contact complémentaire (8),
la première et la seconde couche (21, 22) ayant au moins un contact (31) sur les côtés intérieurs des couches (40) tournés l'un vers l'autre, avec les contacts (31) pouvant être reliés aux contacts complémentaires (27) de la pièce de contact complémentaire (8) située sur le côté supérieur et le côté inférieur (25, 26).

19. Procédé de fabrication d'une liaison électrique et mécanique (4), solidaire entre une pièce de contact (7) ayant plusieurs contacts (31) et une pièce de contact complémentaire (8) ayant plusieurs contacts complémentaires (27), notamment selon l'une des revendications 1 à 17,
**caractérisé en ce que**
la pièce de contact (7) est élargie à son extrémité prévue pour la liaison (4), pour former un espace intermédiaire (23), et les contacts (31) sont prévus sur les côtés intérieurs (40) des couches,
les contacts (31) étant alignés vers les contacts complémentaires (27) et la pièce de contact (7) est ensuite reliée mécaniquement et électriquement à la pièce de contact complémentaire (8).

20. Procédé selon la revendication 19,
**caractérisé en ce que**
pendant et/ou après la réalisation de la liaison (4) il y a un contrôle de la liaison électrique entre les contacts (31) et les contacts complémentaires (27).
